Europäisches Patentamt

(19) European Patent Office

Office européen des brevets

(11) Numéro de publication: **0 241 067**
B1

(12) **FASCICULE DE BREVET EUROPEEN**

(45) Date de publication du fascicule du brevet: **23.01.91**

(21) Numéro de dépôt: **87200441.1**

(22) Date de dépôt: **10.03.87**

(51) Int. Cl.⁵: **H 03 H 11/04,** H 03 K 17/16, H 03 K 19/00

(54) **Circuit de filtrage pour dispositif intégré de type métal-oxyde-semiconducteur et son application à un tel dispositif.**

(30) Priorité: **25.03.86 FR 8604226**

(43) Date de publication de la demande: **14.10.87 Bulletin 87/42**

(45) Mention de la délivrance du brevet: **23.01.91 Bulletin 91/04**

(84) Etats contractants désignés: **CH DE FR GB IT LI NL**

(56) Documents cités:

E.D.N. ELECTRICAL DESIGN NEWS, vol. 29, no. 2, janvier 1984, pages 137-140,142,144,146,148-150,152, Boston, Massachussetts, US; P. MANNONE: "Careful design methods prevent CMOS latch-up"

NEW ELECTRONICS, vol. 9, no. 2, 27 janvier 1976, pages 20,24-25, Juniper Journals Ltd., Londres, GB; "Analogue switches as c.m.o.s. circuit building blocks"

(73) Titulaire: **PHILIPS COMPOSANTS 117, quai du Président Roosevelt F-92130 Issy les Moulineaux (FR)**

(84) **FR**

(73) Titulaire: **N.V. Philips' Gloeilampenfabrieken Groenewoudseweg 1 NL-5621 BA Eindhoven (NL)**

(84) **CH DE GB IT LI NL**

(72) Inventeur: **Labrousse, Michel Société Civile SPID 209, rue de l'Université F-75007 Paris (FR)** Inventeur: **Paquet, Christian Société Civile SPID 209, rue de l'Université F-75007 Paris (FR)**

(74) Mandataire: **Pinchon, Pierre Société Civile S.P.I.D. 156, Boulevard Haussmann F-75008 Paris (FR)**

**Description**

La présente invention concerne un circuit de filtrage, dans un dispositif intégre du type à transistors MOS alimenté à partir de deux bornes, dont une, (positive) est appelée VDD et l'autre, de référence à tension nulle est appelée VSS, circuit de filtrage qui comporte deux transistors MOS, chacun des deux transistors ayant sa grille connectée au drain de l'autre transistor.

De manière générale, il est souvent souhaitable de filtrer des signaux à un stade déterminé de leur traitement au sein d'un dispositif intégré, d'une part en vue d'éliminer des signaux parasites susceptibles de fournir des signaux erronés en sortie, et/ou, d'autre part dans le but d'éviter la destruction d'éléments fragiles du dispositif, lors du passage de signaux parasites de forte amplitude. A cer dernier point de vue, les transistors MOS sont bien connus comme étant très fragiles par leur électrode de grille. Cette électrode est un effet isolée du substrat par une couche diélectrique mince, qui est susceptible de perçage irréversible si des tensions dépassant quelques dizaines de volts sont appliquées.

En ce qui concerne les bornes d'entrée et éventuelement de sortie de signaux dans un dispositif intégré, on dispose le plus souvent immédiatement à proximité de ces bornes, un élément de protection, diode zener par exemple, destiné à limiter la tension sur chaque borne à une valeur maximale convenable tandis que les signaux utiles, qui ont une amplitude inférieure à cette valeur maximale, ne sont pas affectés par ce élément de protection. Le traitement numérique des signaux, peut faire appel également à une ou plusieurs étapes de filtrage de manière à éliminer le bruit contenu dans les signaux d'entrée et à réduire ainsi les risques de faux résultats en sortie ayant le bruit ou des signaux parasites comme origine.

Il est clair qu'un circuit de filtrage tendant à éliminir des signaux de bruit à fréquence plus élevée que la fréquence de travail (filtre passe bas par exemple) est apte, par nature, à réduire l'amplitude et donc, à assurer une protection des éléments fragiles du dispositif intégré, tout au moins en ce que concerne des signaux parasites très brefs.

Un circuit de filtrage du type indiqué en préambule est notamment connu du brevet français n° 2045050.

Dans ce document, on indique comment un signal peut être mis en forme par passage dans un circuit de filtrage ayant à la fois une caractéristique de réponse à hystérsis et à la fois les propriétés d'un filtre passe bas de type RC.

L'invention vise cependant à fournir une solution à un problème quelque peu différent puisque qu'elle n'envisage pas de traiter un signal mumérique proprement dit, mais s'intéresse à la transmission vers certains points sensibles d'un dispositif intégré, des tensions VDD et VSS qui sont elles-mêmes susceptibles de véhiculer des fluctuations parasites très brèves, d'origine externe ou interne.

A cet effet un circuit de filtrage, dans un dispositif intégré du type à transistors MOS alimenté à partir de deux bornes, dont une, (positive) est appelée VDD et l'autre, de référence à tension nulle, est appelée VSS, circuit de filtrage qui comporte deux transistors MOS, chacun des deux transistors ayant sa grille connectée au drain de l'autre transistor est remarquable en ce que, en vue de la fourniture des tensions VDD et VSS à des grilles d'autres transistors du dispositif intégré, lesdits deux transistors du circuit de filtrage sont de types complémentaires, le premier transistor, dont la source est connectée à VSS, a son drain constituant une sortie à tension V'SS filtrée et voisine de VSS, tandis que le deuxième transistor, dont la source est connecté à VDD, a son drain constituant une sortie à tension V'DD filtrée et voisine de VDD.

Un tel circuit possède a priori deux états possibles, un état dans lequel les deux transistors sont à haute impédance et un autre état où ils sont tous les deux conducteurs. Ce dernier état cependant, est très stable tansis que le premier ne l'est pas et dépend des charges appliquées aux sorties V'DD et V'SS. Comme le circuit de filtrage de l'invention est destiné à l'alimentation exclusive de grilles de transistor MOS, les charges de sortie de ce circuit sont de type purement capacitif c'est-à-dire d'impédance extrêmement élevée. Par comparaison, l'impédance drain-source des deux transistors, dans leur état non conducteur, est très sensiblement plus faible, de sorte que dans le cas défavorable où, lors de la mise sous tension, le circuit de filtrage se trouvait un court instant dans son état non conducteur, il retomberait nécessairement dans son état stable fournissant en sortie les tensions filtrées V'DD et V'SS telles que mentionnées.

Ces tensions peuvent être appliquées en toure sécurités sur des grilles de transistors MOS pour des usages spécifiques alors que les tensions non filtrées VDD et VSS sont par ailleurs appliquées de manière connue, sur des drains ou des sources des transistors du reste du dispositif intégré, ces électrodes n'ayant pas la fragilité des grilles.

A titre d'exemple l'application de tensions V'DD et V'SS directement à des grilles de transistores MOS peut être requise pour obtenir au moyen de ces transistors, soit des resistances de valeur bien définie, soit une tension décalée en-dessous de VDD de la valeur d'une tension de seuil, soit encore pour positionner à "1" ou "0" une entrée d'un bloc fonctionnel, notamment dans le cas d'un circuit d'essais ne possédant, à une stade intermédiaire de développement, qu'une partie seulement des blocs fonctionnels prévus, le positionnement fixe tenant lieu alors de signal de sortie d'un bloc omis provisoirement à ce stade du développement.

A la mise sous tension, le circuit de filtrage de l'invention peut requérir un certain délai pour se positionner dans son état conducteur ce que n'est pas un inconvénient en générale, étant donné que la procédure d'initialisation d'un circuit logique complexe, microprocesseur par exemple, est suffisamment longue pour que le positionnement correct du circuit de filtrage soit intervenu entre temps.

Toutefois, si on le désire, lors de la mise sous tension la durée de basculement éventuel du circuit de filtrage peut être considérablement réduite selon un mode de mise en oeuvre de l'invention caractérisé en ce qu'il comporte un troisième transistor dont la source est connectée à l'une des tensions VSS (ou VDD) tandis que sa grille et son drain sont ensemble connectés à la sortie filtrée de tension équivalents V'SS (ou VDD).

Ledit troisième transistor peut être un transistor MOS à canal N; il a alors sa source connectée à VSS tandis que sa grille et son drain sont connectés ensemble à la sortie V'SS. Dans le cas défavorable où à l'instant de la mise sous tension la sortie V'SS se trouvait portée à un potentiel positif tel que les premier et deuxième transistors soient non conducteurs à cet instant, c'est alors le troisième transistor qui serait conducteur et abaisserait très rapidement la tension de sortie V'SS jusqu'à ce que le deuxième transistor, devenant conducteur, accélère encore le basculement du circuit dans son état stable définitif. Dans ce dernier état, le troisième transistor ne conduit plus de sorte que son rôle n'intervient qu'un court instant à l'initialisation, et seulement si l'état défavorable se produisait. Il est facile de voir que pour remplir sa fonction, il n'est pas nécessaire que la troisième transistor présente une conductance élvée à l'état passant. Aussi peut-on prévoir à cet usage le plus petit transistor compatible avec les tolérances du procédé utilisé. Par raison de symétrie du circuit de l'invention, à la place d'un transistor à canal N, on peut encore utiliser un transistor à canal P, comme troisième transistor. Dans ce cas, il a source connectée à VDD tandis que sa grille et son drain sont connectés ensemble à la sortie V'DD.

Le fonctionnement et le résultat seront similaires aus cas précédent à ceci près que le délai d'initialisation, lorsque cette initialisation doit se produire, serait un peu plus long eu égard à la plus faible conduction d'un transistor à canal P comparée à celle d'un transistor à canal N de même taille.

D'autres détails et particularitiés de mise en oeuvre seront mis en évidence par la description qui va suivre en regard des dessins annexés le tout donné à titre d'exemples non limitatifs, dans lequels:

La figure 1 représente un schéma électrique du circuit de filtrage selon l'invention,

La figure 2 donne un schéma électrique du circuit de filtrage de l'invention dans une variante de mise en oeuvre, et

La figure 3 représenté par une vue en plan, un mode de réalisation particulièrement avantageux du circuit correspondant au schéma de la figure 2, figure dans laquelle les connexions métalliques ont été représentées de manière symbolique.

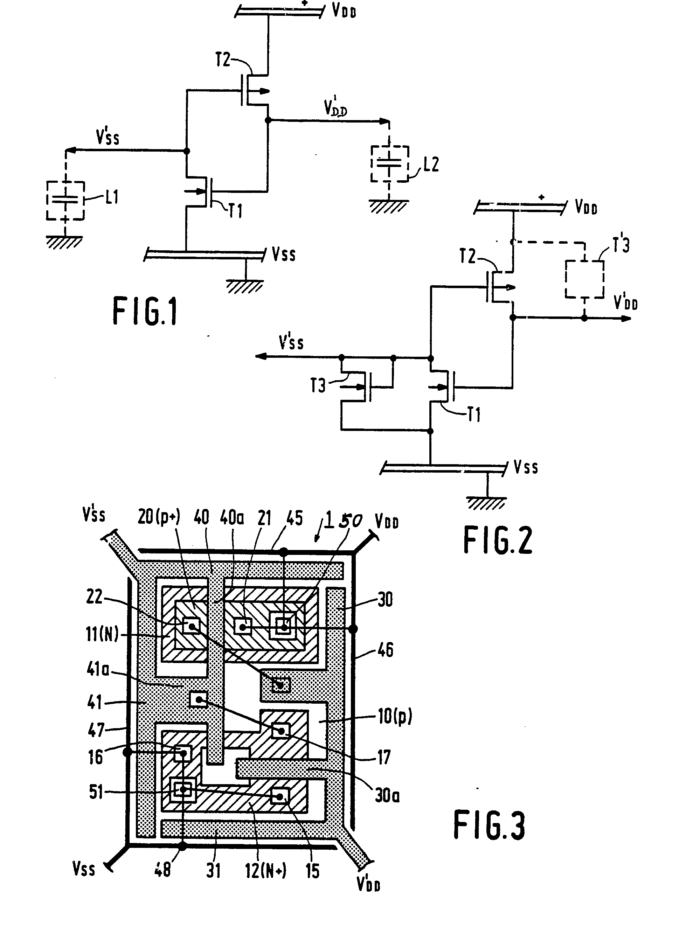

On se réfère à la figure 1 qui indique le schéma d'un circuit de filtrage selon l'invention composé de deux transistors, un premier transistor T1 de type MOS à canal N ayant sa source connectée au rail d'alimentation à tension VSS et son drain connecté à la grille d'un deuxième transistor T2, de type MOS à canal P. Le transistor T2 a sa source connectée au rail d'alimentation de tension positive VDD, tandis que son drain est connecté à la grille du transistor T1. Le noeud commun au drain du transistor T1 et à la grille du transistor T2 fournit une sortie V'SS, filtrée et voisine de VSS. De manière analogue, le noeud commun au drain du transistor T2 et à la grille du transistor T1 fournit une sortie à tension V'DD, voisine de VDD mais filtrée.

Comme il a déjà été indiqué, les tensions de sortie V'SS et V'DD sont destinées à alimenter des grilles d'autres transistors MOS du dispositif intégré. Aussi, les charges appliquées à ces sorties, symbolisées en pointillé respectivement par L1 et L2 sont-elles de nature purement capacitive. C'est pourquoi, si à la mise en service, le circuit de filtrage représenté devait initialement se trouver dans un état tel que les transistors T1 et T2 ne soient pas conducteurs, les trajets source-drain de ces transistors auraient alors une impédance très inférieure à l'impédance purement capacitive des grilles de transistors MOS de sorte que ce circuit basculerait nécessairement vers son état stable dans lequel les transistors T1 et T2 sont tous deux conducteurs. C'est dans cet état, maintenu par le couplage croisé drain-grille des transistors T1 et T2, que les tensions VSS et VDD sont transmises, via les trajets conducteurs respectifs des transistors T1 et T2, vers les sorties respectives équivalentes V'SS et V'DD.

L'insertion des trajets conducteurs T1 et T2, trajets dont la résistance peut néanmoins valoir quelques centaines d'ohms, jointe aux capacités parasites des électrodes vis-à-vis du substrat, joue le rôle d'un filtre passe-bas qui atténue les signaux parasites à fronts très raides éventuellement présents sur les rails d'alimentation. Les transistors dont les grilles sont polarisées à partir de V'SS ou V'DD sont donc protégés contre des surtensions à fronts raides susceptibles d'endommager le diélectrique d'isolement desdites grilles.

La figure 2 donne le schéma électrique d'une variante du circuit de filtrage de la figure 1, schéma dans lequel les éléments communs à ceux de la figure 1 sont affectés des mêmes signes repères.

Par rapport au circuit de la figure 1, le circuit de la figure 2 diffère seulement par l'adjonction d'un troisième transistor, T3, de type MOS à canal N dont la source est connectée à la source du transistor T1, et dont la grille et le drain sont ensemble connectés au noeud procurant la sortie à tension V'SS. Le transistor T3 ne conduit qu'un très court instant lors de la mise sous tension et seulement si le noeud à tension V'SS devait se trouver porté à une tension positive, et le noeud à tension V'DD simultanément porté à une tension voisine de VSS ou inférieure.

Les charges électriques portées par les conducteurs du noeud V'SS sont alors très rapidement écoulées vers VSS par le transistor T3 tandis que durant ce processsus le transistor T2 accélère ensuite, le basculement en devenant conducteur à son tour. Lorsque la tension V'SS tend vers le valeur de la tension VSS, le transistor T3 cesse d'être conducteur et reste dans cet état bloqué durant la suite du fonctionnement du dispositif. Le transistor T3 a donc uniquement pour rôle d'accélérer le processus de basculement du circuit de filtrage vers son état définitif, lors de la mise sous tension, et dans le cas seulement où ce basculement aurait été nécessaire.

Le schéma de la figure 2 a montré l'utilisation d'un transistor T$_3$ ayant pour rôle d'accélérer le basculement du circuit formé par les transistors T$_1$ et T$_2$ lorsque l'état transitoire de ce circuit est défavorable à l'instant de la mise sous tension. Cependant, le même effet peut être obtenu en supprimant le transistor T$_3$ et an ajoutant un transistor T'$_3$ de type MOS à canal P, dont la source est connectée à la source du transistor T$_2$ et dont la grille et le drain sont ensemble connectés au noeud de sortie à tension V'DD, la disposition du transistor T'$_3$ est schématisée en tirets sur la figure 2.

La figure 3 représente un exemple de réalisation particuliérement avantageuse du circuit de la figure 2, sous forme d'un motif 1 à contour pratiquement rectangulaire.

On utilise pour obtenir les zones actives et les contacts conducteurs, les techniques par ailleurs bien connues des spécialistes du domaine des dispositifs intégrés à transistor MOS complémentaires, et qu'il n'est pas utile de décrire ici.

Le substrat semi-conducteur 10, de type P est représenté en zones claires sur la figure, dans le mesure où il est apparent en surface. Une région superficielle de type N dite "poche N", est localisée à la surface du substrat 10, en vue de recevoir les régions actives du transistor T2, à canal P. Une autre région superficielle 12, de type N+, qui affecte grossièrement la forme d'une couronne, constitue simultanément les régions de source et de drain des transistors T1 et T3.

Les transistors T1 et T3 présentant respectivement une fenêtre de contact de source 15 et 16, tandis que la région de drain est commune à ces deux transistors et possède une fenêtre de contact de drain 17.

Les régions de source et de drain du transistor T2 sont constituées par une zone superficielle 20 de type P+ contenue dans le poche N 11, où se situent le fenêtre de contact de source 21, et la fenêtre de contact de drain 22.

L'électrode de grille des transistors T1, T2 et T3 est, dans cet exemple, constituée par une couche de matériau semiconducteur polycristallin rendu conducteur par dopage. Cette couche est divisée en deux portions isolées l'une de l'autre. La première, a une bordure qui affecte la forme d'un L s'étendant le long de deux côtés adjacents du motif 1, et dont une branche 30 fournit, par une dent 30a, dirigée vers l'intérieur du circuit, la grille du transistor T1. Le rôle de la branche 31 de la même portion sera expliqué ci-aprés. La deuxième portion de couche polycristalline a également une bordure en forme de L, et est située symétriquement par rapport au centre du rectangle formé par le motif 1 du circuit, dont une branche 40 fournit, par une dent 40a, dirigée vers l'intérieur du circuit, la grille du transistor T2, et l'autre branche 41 fournit par une dent 41a (par ailleurs reliée à la dent 40a) la grille du transistor T3.

Une couche métallique de contact, située au niveau supérieur, et généralement isolée des autres électrodes et régions sauf à l'emplacement des fenêtres de contact, est découpée selon la configuration nécessaire, qui a été représentée sur la figure 3, de manière symbolique (par des fils) pour plus de clarté.

La configuration métallique de contact comporte deux portions périphérique, isolées l'une de l'autre, dans lesquelles une bordure presente également une forme en L. Les branches 45 et 46 de la bordure l'une première portion de couche de contact s'étendant le long deux côtés adjacentes du motif 1 tandis que les branches 47 et 48 de la bordure de la deuxième portion de contact s'étendent le long des deux autres côtés adjacentes du motif. Ainsi, pour un même niveau de couche de contact, les bordures en forme de L appartenant à des portions isolées de cette couche, sont disposées par paires opposées par rapport au centre du motif. Cependant, la disposition par paires opposées est pivoté d'un quart de tour en ce qui concerne les portions de couches de contact de premier niveau par rapport à celles de deuxième niveau.

Le dessin de la figure 3, montre les branches 45, 46—47, 48 des bordures de couche de contact (de niveau supérieur), placées à l'extérieur des branches 30, 31—40, 41 de couche polycristalline, (du niveau inférieur). Or cette représentation n'a été donnée que dans un brut de clarté de la figure mais 11 est évident qu'en pratique les deux branches s'étendant le long d'un même côté peuvent être superposées puisqu'elles sont isolées l'une de l'autre par une couche diélectrique.

Les branches 45 et 46 portent la tension VDD et sont en liaison par une fenêtre 50 de contact avec la poche N11, et avec la fenêtre 21 de contact de source du transistor T2.

Les branches 47 et 48 portent la tension VSS et sont en liaison avec une fenêtre 51 de contact substrat, avec la fenêtre 16 de contact de source du transistor T3 et avec la fenêtre 15 de contact de source du transistor T1.

Les branches 30 et 31 formant bordure d'une portion de couche polycristalline, fournissent le tension V'DD et sont en liaison avec le fenêtre 22 de contact drain du transistor T2. Les branches 40 et 41 formant bordure de l'autre portion de couche polycristalline, fournissent la tension V'SS qui est reliée à la fenêtre 17 de contact de drain commun des transistors T1 et T2.

Un avantage essentiel de cette disposition particulière réside dans la facilité d'accès aux quatre tensions du motif, par des connexions courtes, en un point quelconque des quatre bordures en forme de L, compte-tenu du fait que le motif 1 peut être implanté selon quatre orientations différentes, déduites l'une de l'autre par pivotement d'un quart de tour. A cet égard, la représentation des entrées et sorties de VSS, VDD, V'SS, V'DD, en diagonales dans les angles des bordures en forme de L, n's été donnée qu'à titre symbolique, et il est clair que ces entrées et sorties seront pratiquées à tour emplacement convenable en fonction de la topographie de dispositif intégré avoisinant.

L'invention concerne également une application du circuit de filtrage déjà décrit, à un dispositif intégré complexe partagé en blocs fonctionnels répartis à la surface du substrat semi-conducteur, applications selon laquelle ce circuit de filtrage est implanté autant de fois que le dispositif intégré comporte de blocks fonctionnels particuliers nécessitant une alimentation de grille de transistor à au moins une des tensions fixes, VSS ou VDD, chaque circuit de filtrage individuel étant disposé à promimité d'un desdits blocs fonctionnels particuliers et alimentant exclusivement les transistors concernés de ce bloc.

Ce mode d'application a l'avantage de procurer une excellente efficacité du filtrage puisque ce sont les lignes non filtrées VSS et VDD qui sont longues, et par contre les lignes filtrées V'SS et V'DD qui sont courtes et qui sont donc peu sujettes à l'influence de signaux parasites d'origine interne.

De plus, des motifs de circuit de filtrage tels que celui représenté à la figure 3, peuvent être prévus d'une taille très petite (36×50 micromètres); il n'occupent donc que peu de place au sein du dispositif intégré complexe et assurent une relative indépendance d'alimentation de chacun des blocs fonctionnels particuliers nécessitant une connexion de grille de transistor à l'une ou l'autre des tensions fixes.

**Revendications**

1. Circuit de filtrage, dans un dispositif intégré du type à transistors MOS alimenté à partir de deux bornes, dont une, (positive) est appelée VDD et l'autre, de référence à tension nulle, est appelée VSS, circuit de filtrage qui comporte deux transistors MOS, chacun des deux transistors ayant sa grille connectée au drain de l'autre transistor, caractérisé en ce que en vue de la fourniture des tensions VDD et VSS à des grilles d'autres transistors du dispositif intégré, lesdits deux transistors du circuit de filtrage sont de types complémentaires, le premier transistor, dont la source est connectée à VSS, a son drain constituant une sortie à tension V'SS filtrée et voisine de VSS, tandis que le deuxième transistor, dont la source est connectée à VDD, a son drain constituant une sortie à tension V'DD filtrée et voisine de VDD.

2. Circuit de filtrage selon la revendication 1, caractérisé en ce qu'il comporte un troisième transistor dont la source est connectée à l'une des tensions VSS (our VDD) tandis que sa grille et son drain sont ensemble connectés à la sortie filtrée de tension équivalents V'SS (ou V'DD).

3. Circuit de filtrage selon l'une des revendications 1 ou 2 réalisé par intégration dans un substrat semiconducteur sous forme d'un motif à contour pratiquement rectangulaire comportant deux niveaux distincts de couche conductrice de contact, caractérisé en ce que les tensions VSS, VDD, V'SS, V'DD sont portées par des portions de couche conductrice à raison de deux de ces tensions pour deux portions isolées de même couche conductrice, et en ce que les portions de couche conductrice ont une bordure en forme de L qui pour chacune s'étend le long de deux côté adjacents dudit contour rectangulaire, les bordures en forme de L étant disposées par paires opposées par rapport au centre du motif pour deux portions d'une couches de même niveau, et la disposition étant pivotée d'un quadrant en ce que concerne les portions de couches de niveau différent.

4. Application du circuit de filtrage selon l'une des revendications 1 à 3 un dispositif intégré complexe partagé en blocs fonctionnels répartis à la surface du substrat semi-conducteur, caractérisée en ce que ledit circuit de filtrage est implanté autant de fois que le dispositif intégré comporte de blocs fonctionnels particuliers nécessitant une alimentation de grille de transistor à au moins une des tensions fixes, haute ou basse, chaque circuit individuel étant disposé à proximité d'un desdits blocs fonctionnels particuliers et alimentant exclusivement les transistors concernés de ce bloc.

**Patentansprüche**

1. Filterschaltung in einer integrierten Einrichtung, vom Typ mit MOS-Transistoren, gespeist aus zwei Klemmen, wobei eine (positive) Klemme mit VDD und die andere auf Bezugs-Nullspannung mit VSS bezeichnet wird, wobei die Filterschaltung zwei MOS-Transistoren enthält, die jeweils mit ihrem Gate an den Abzug des anderen Transistors angeschlossen ist, dadurch gekennzeichnet, daß bezüglich der Zuleitung der VDD- und VSS-Spannungen zur den Gates anderer Transistoren der integrierten Einrichtung die beiden Transistoren der Filterschaltung vom Komplementärtyp sind, wobei der Abzug des ersten Transistors, dessen Quelle mit VSS verbunden ist, einen Ausgang mit einer gefilterten Spannung V'SS in der Nähe von VSS darstellt, während der Abzug des zweiten Transistors, dessen Quelle mit VDD verbunden ist, einen Ausgang mit einer gefilterten Spannung V'DD in der Nähe von VDD darstellt.

2. Filterschaltung nach Anspruch 1, dadurch gekennzeichnet, daß darin ein dritter Transistor vorgesehen ist, dessen Quelle mit einer der Spannung VSS (oder VDD) verbunden ist, während sein Gate und sein Abzug zusammen mit dem gefilterten Ausgang auf einer Spannung gleich V'SS (oder V'DD) verbunden sind.

3. Filterschaltung nach einem der Ansprüche 1 oder 2, die durch Integration in ein Halbleitersubstrat in Form eines Musters mit einem nahezu rechteckigen Umriß, das zwei unterschiedliche Kontaktleitschichtebenen besitzt, dadurch gekennzeichnet, daß die Spannungen VSS, VDD, V'SS und V'DD durch Leitschichtteile weitergeleitet werden, wobei je zwei dieser Spannungen durch zwei isolierte Teile derselben Leichtschicht weitergeleitet werden, und daß die Leitschichtteile eine Umrandung in Form des Buchstaben L besitzen, die sich jeweils entlang der zwei benachbarten Seiten des rechteckigen Umrisses erstrecken, wobei die L-förmigen Umrandungen in bezug auf die Mustermitte für zwei Teile einer Schicht derselben Ebene einander gegenüber paarweise angeordnet sind, und daß diese Anordnung in bezug auf die Teile von Schichten auf unterschiedlicher Ebene um eine Vierteldrehung gedreht ist.

4. Anwendung der Filterschaltung nach einem der Ansprüche 1 bis 3 auf einer zusammengesetzten integrierten Einrichtung, die in auf die Oberfläche des Halbleitersubstrats verteilte Funktionsblöcke aufgeteilt ist, dadurch gekennzeichnet, daß die Filterschaltung so oft implantiert ist, wie die integrierte Einrichtung typische Funktionsblöcke trägt, die eine Transistorgatespeisung mit wenigstens einer der festen hohen oder niedrigen Spannungen erfordern, wobei jede einzelne Schaltung in der Nähe eines der erwähnten Funktionsblöcke angeordnet ist und ausschließlich die anfallenden Transistoren dieses Blocks speist.

**Claims**

1. A filter circuit in an integrated device of the type comprising MOS transistors powered *via* two terminals, one of which (positive) is referred to as VDD whils the other terminal, carrying the reference voltage zero, is referred to as VSS, which filter circuit comprises two MOS transistors, the gate of each transistor being connected to the drain of the other transistor, characterized in that, in order to supply the voltage VDD and VSS to the gates of the other transistors of the integrated device, said two transistors of the filter circuit are of a complementary type, the drain of the first transistor, whose source is connected to VSS, forming an output for a filtered voltage V'SS which approximates VSS, whilst the drain of the second transistor, whose source is connected to VDD, forms an output for a filtered voltage V'DD which approximates VDD.

2. A filter circuit as claimed in Claim 1, characterized in that it comprises a third transistor whose source is connected to one of the voltages VSS (or VDD), whilst its gate and its drain are connected together to the equivalent filtered voltage output V'SS (or V'DD).

3. A filtered circuit as claimed in any one of the Claims 1 or 2 and constructed by integration in a semiconductor substrate in the form of a pattern having a substantially rectantular contour, and comprising two distinct levels of conductive contact layers, characterized in that the voltages VSS, VDD, V'SS, V'DD are carried by conductive layer portions, with each time two of these voltages in two insulated portions of the same conductive layer, the conductive layer portions having a respective L shaped border which extends each time along two adjacent sides of said rectantular contour, the L shaped borders being arranged in opposite pairs with respect to the centre of the pattern for two portions of a layer of the same level, the arrangement being rotated through one quarter of a turn for the portions of layers of a different level.

4. The use of the filter circuit as claimed in any one of the Claims 1 to 3 in a complex integrated device which is subdivided into functional blocks distributed across the surface of the semiconductor substrate, characterized in that said filter circuit is implanted as many times as the integrated device comprises specific functional blocks requiring powering of the gate of the transistor by at least one of the fixed voltages, high or low, each individual circuit being arranged in the vicinity of one of said specific functional blocks and powering exclusively the respective transistors of this block.

EP 0 241 067 B1

FIG.1

FIG.2

FIG.3